Europäisches Patentamt

European Patent Office

Office européen des brevets

(19)

(11) Publication number: **0 365 357**
**A2**

# (12) EUROPEAN PATENT APPLICATION

(21) Application number: 89310845.6

(51) Int. Cl.5: **G03F 3/10**

(22) Date of filing: 20.10.89

(30) Priority: 21.10.88 US 260789

(43) Date of publication of application:
25.04.90 Bulletin 90/17

(84) Designated Contracting States:
AT BE CH DE ES FR GB GR IT LI LU NL SE

(71) Applicant: HOECHST CELANESE
CORPORATION
Route 202-206 North
Somerville, N.J. 08876(US)

(72) Inventor: Dunder, Thomas
Route 5, Box 230-EL
Chapel Hill North Carolina(US)
Inventor: Platzer, Stephan J.W.
zum Steinmorgen24
D-6228Eltville2(DE)

(74) Representative: De Minvielle-Devaux, Ian
Benedict Peter et al
CARPMAELS & RANSFORD 43, Bloomsbury
Square
London WC1A 2RA(GB)

(54) Negative-working, photo-polymerizable color proofing film without triplet oxygen quenching.

(57) This invention relates to negative-working photosensitive color proofing system which can accurately reproduce said image by using a photosensitive layer containing an admixture of a diazonium compound and a photopolymerizable composition. The final construction is useful in predicting the image quality from a lithographic printing press.

EP 0 365 357 A2

Background of the Invention

The present invention relates to a radiation-polymerizable composition. More particularly, this invention relates to a radiation-polymerizable composition which may be employed to produce an improved photoimaging color proofing film. The use of radiation-polymerizable coatings in the graphic arts is well known. Typically, the composition of such coatings can include a polymeric constituent, which may itself be radiation-polymerizable, and a photosensitizer composition. Upon selected exposure of this coating to imaging energies, the radiation-polymerizable species within the composition would either itself undergo a reaction or promote a reaction or degradation of one or more of the other components of the composition. It is, of course, readily appreciated that such reaction is only of value in such a system where it is essentially confined to those areas of the composition impinged upon by such imaging energies. A negative working image thus created within the coating can then be "developed" by selective removal of the nonexposed components of the film or layer which have not been subjected to imaging energies. The ability to create such selective changes in coatings prepared from a radiation-polymerizable composition has been appreciated for some time. The basic difference in the various approaches in the formulation of color proofing films from radiation-polymerizable compositions has been in the search for a system which is prepared from relatively inexpensive ingredients, has a high quantum efficiency, and results in the creation of high resolution images within the composition which can be manifested without prolonged and elaborate development and, significantly, may be developed with a composition which does not necessarily contain organic solvents and which need contain only a minor amount of salts and surfactants. Various processes for producing copies of an image embodying a photopolymerization are known, as described in U.S. Patents 3,060,023; 3,060,024; 3,060,025; 3,481,736 and 3,607,264. Photopolymerizable imaging systems typically comprise an unsaturated monomer, a free-radical initiator which is activated by actinic radiation, and binder resins, colorants and the other optional additives as hereinbefore mentioned.

In the production of free-radical initiated photopolymerizable coatings, it is widely recognized that such reactions are subject to a quenching phenomenon by triplet oxygen of the free-radicals formed by irradiating the initiator. The premature return of the free-radicals to the energy ground state precludes the required energy transfer necessary to effect the polymerization reaction.

In the reprographics industry, it is desirable to produce a color proof to assist a printer in correcting color separation films prior to using them to produce printing plates. The proof should reproduce the color quality that will be obtained during the printing process. The proof must be a consistent duplicate of the desired half tone or line image. Visual examination of a color proof should show the color rendition to be expected from press printing using the color separations and any defects on the separations which might need to be altered before making the printing plates.

Color proofing sheets for multicolored printing can be made by using a printing press or proof press. This requires that all of the actual printing steps be performed. Therefore, this conventional method of color proofing is costly and time consuming.

Photoimaging processes can also be used to produce a color proof. There are two general types of photoimaging methods: namely the overlay type and the single sheet type.

In the overlay type of color proofing method, an independent transparent plastic support is used for producing an image of each color separation film by applying a photosensitive solution of the corresponding color. A plurality of such supports carrying images of the corresponding colors are then superimposed upon each other over a white sheet to produce a color proofing composite. The primary advantage of the overlay method is that proofs can be made quickly and can serve as a progressive proof by combining any two or three colors in register. However, this type of color proofing method has the disadvantage that the superimposed plastic supports tend to darken the color proofing sheet. As a result, the impression of the color proofing composite thus prepared is vastly different from that of copies actually obtained with conventional printing presses and with proof presses. Examples of such overlay approaches are contained in U.S. Patents 3,136,637; 3,211,553; and 3,326,682.

In the single sheet type of color proofing method, a color proofing sheet is prepared by successively producing images of different colors from different color separation films on a single receiver sheet. This can be accomplished by sequentially applying colorants or colored, photosensitive layers to a single opaque support. This method more closely resembles the actual printing process and eliminates the color distortion inherent in the overlay system. Examples of such single sheet approaches are contained in U.S. Patents 3,671,236; 4,260,673; 4,366,223; 4,650,738; 4,656,114; and 4,659,642.

2

U.S. Patent 4,596,757 provides a method for transferring images or solid colors which are subsequently imaged. The photosensitive material comprises a carrier support having sequentially disposed thereon a release layer; a colored, photopolymerizable layer; and an adhesive layer. The material can undergo exposure, lamination to a temporary support, wet development, and then lamination to a receptor sheet. Alternatively, the photosensitive material can be laminated to a receptor sheet, undergo exposure, and then wet processed. The present invention improves upon this composition by providing a color proofing film having high light sensitivity and reducing or substantially preventing triplet oxygen quenching.

Summary of the Invention

The present invention provides a multilayered imaging element which comprises, in order:
i. a transparent support having a release surface, and
ii. a single, colored photosensitive composition layer directly on said release surface which photosensitive layer comprises in admixture a light sensitive component which component comprises both a polymeric diazonium compound and a photopolymerizable composition, at least one binding resin, and at least one colorant; wherein said polymerizable composition and diazonium compound are present in sufficient amount to cause image differentiation when the composition is imagewise exposed to actinic radiation; wherein said binding resin is present in sufficient amount to bind the photosensitive layer components into a uniform film; and wherein said colorant or colorants are present in sufficient amount to uniformly color said colored layer; and
iii. a heat sensitive adhesive layer directly on said colored photosensitive layer.
The invention also provides a method for forming a colored image which comprises:
A. providing the aforementioned element and then
B. either
i. laminating said element with heat and pressure via said adhesive layer to a developer resistant receiver sheet; and removing said support by the application of peeling forces; and imagewise exposing said photosensitive layer to actinic radiation; or
ii. imagewise exposing said photosensitive layer to actinic radiation; and laminating said element with heat and pressure via said adhesive layer to a developer resistant receiver sheet; and removing said support by the application of peeling forces; or
iii. laminating said element with heat and pressure via said adhesive layer to a developer resistant receiver sheet; and imagewise exposing said photosensitive layer to actinic radiation; and removing said support by the application of peeling forces; and
C. removing the nonexposed areas of said photosensitive layer with a liquid developer, which removing is conducted at a temperature at which said adhesive layer is substantially nontacky; and
D. optionally repeating steps (A) through (C) at least once whereby another photosensitive element having at least one different colorant is laminated onto said receiver sheet over the nonremoved portions of the previously laminated colored layer or layers.

Detailed Description of the Preferred Embodiment

In the production of the invention, one provides a photographic element which broadly comprises a transparent support having a release surface, a colored photosensitive layer on the release surface, and an adhesive layer on the colored photosensitive layer. The transparent support is preferably composed of a dimensionally and chemically stable base material which does not significantly change its size, shape, or chemical properties as the result of the heating, coating, or other treatments which it must undergo. The support may be composed of any suitable flexible sheet material. One preferred material is polyethylene terephthalate. In the usual case it has a thickness of from about 1 to about 10 mils, a more preferred thickness is from about 2 to about 5 mils, and most preferably from about 2 to about 3 mils. Suitable films nonexclusively include Hostaphan 3000 available from Hoeschst Celanese Corporation, Mylar D available from Dupont; and Melinex 516 available from ICI. The surface of the support may be smooth or may be provided with a matte texture by various methods known in the art.

Matte films include Melinex 377 and 470 available from ICI. These materials have the unique property of giving the final image a desired matte finish without any extra steps. One can control the gloss of the final image by properly selecting the matte finish of the temporary support. This effect works because the top layer of the final image is originally in contact with this matte surface. This does not generally occur with a separate protective layer between the transparent support and photosensitive layer. An additional advantage of coating on a matte surface is that subsequent transferred layers generally adhere better to a rough surface than to a smooth surface.

A similar matte finish of the final image can be obtained by embossing the shiny, top surface of the image with a matte material, such as described above. This is done by laminating together the final image and matte material with heat and pressure. The matte material is then generally removed after lamination. The advantage of this method is that the finish of the final proof can be varied. Furthermore, the matting material can be used repeatedly.

A matte finish can also be prepared by a heat transferable layer, such as Butvar 90, available from Monsanto, coated onto a film with a rough surface, such as Melinex 329, available from ICI. The transferable layer is laminated to the final image with heat and pressure. Then the film with the rough surface is peeled off. The rough surface imparts a matte finish to the final image. An additional advantage of this method is that the extra transferable layer protects the image. U.S. Patents 4,294,909 and 4,376,159 also suggest various methods for making a matte surface.

The support must have a release surface, that is, it must be capable of releasably holding the photosensitive layer thereto. This may be accomplished either by the support surface being inherently releasable, being rendered releasable by a suitable treatment or being provided with a release layer over the support surface. Such release layers stay with the transparent support when the support is separated from the receiver sheet. They may comprise polyvinyl alcohol.

Releasably bonded to the release surface of the support is the photosensitive layer. The photosensitive layer broadly comprises in admixture a light sensitive component which component comprises both a polymeric diazonium compound and a photopolymerizable composition, at least one binding resin, and at least one colorant.

Other optional ingredients such as plasticizers, acid stabilizers, surfactants, inert fillers, polymerization inhibitors, spectral sensitizers, antihalation agents, hydrogen atom donors, optical brighteners, exposure indicators, antistatic compositions, u.v. absorbers, photoactivators and residual coating solvents may also be present.

The colored photosensitive layer is preferably applied from an organic solvent coating composition. Organic solvents are preferred for the color coating due to the diverse solubility characteristics of the color coat components and due to the nonintrasolvation of any water soluble, release layer. Typical solvents, nonexclusively include methyl ethyl ketone, 2-methoxyethanol, 1-methoxy-2-propanol, 4-hydroxy-4-methyl-2-pentanone, tetrahydrofuran, and gamma-butyrolactone. In general, the solvent or solvents are evaporated from the coating composition once it is applied to an appropriate substrate. However, some insignificant amount of solvent may remain in the dried coating.

The photopolymerizable material contained in the colored, photosensitive layer comprises an addition polymerizable, nongaseous (boiling temperature above $100°C$ at normal atmospheric pressure), ethylenically-unsaturated compounds containing at least two terminal ethylene groups, and being capable of forming a high molecular weight polymer by free radical initiated, chain propagating addition polymerization. Suitable polymerizable materials nonexclusively include triethylene glycol dimethacrylate, tripropylene glycol diacrylate, tetraethylene glycol dimethacrylate, diethylene glycol dimethacrylate, 1,4-butanediol diacrylate, 1,6-hexanediol dimethacrylate, pentaerythritol tetraacrylate, trimethylol propane triacrylate, trimethylol propane trimethacrylate, di-pentaerythritol monohydroxypentaacrylate, pentaerthritol triacrylate, bisphenol A ethoxylate dimethacrylate, trimethylolpropane ethoxylate triacrylate, and trimethylolpropane propoxylate triacrylate.

Free radical liberating photoinitiators include any compound which liberate free radicals on stimulation by actinic radiation. Preferred photoinitiators nonexclusively include quinoxaline compounds as described in U.S. Patent 3,765,898; the vicinal polyketaldonyl compounds in U.S. Patent 2,367,660; the alpha-carbonyls in U.S. Patents 2,367,661 and 2,367,670; the acyloin ethers in U.S. Patent, 2,448,828; the triarylimidazolyl dimers in U.S. Patent 3,479,185; the alpha-hydrocarbon-substituted aromatic acyloins in U.S. Patent 2,722,512; polynuclear quinones in U.S. Patents 2,951,758 and 3,046,127; and s-triazines in U.S. Patent 4,656,272.

The diazonium salt which is useful in the practice of this invention may be any suitable light-sensitive diazonium polymeric or monomeric compound which are well known to the skilled artisan although the polymeric diazonium compounds are preferred. Suitable diazonium compounds include those condensed with formaldehyde such as disclosed in U.S. Patents 2,063,631 and 2,667,415, the polycondensation products such as disclosed in U.S. Patents 3,849,392 and 3,867,147, and the high photo-speed and co-

4

condensed diazos such as disclosed in U.S. Patents 4,436,804 and U.S. 4,533,620.

Preferably, the diazonium salt comprises the polycondensation product of 3-methoxy-4-diazo-diphenyl amine sulfate and 4,4'-bismethoxy-methyl-diphenyl ether, precipitated as the mesitylene sulfonate, such as is taught in U.S. Patent 3,849,392 and which is incorporated herein by reference.

The colorants useful for the colored, photosensitive layer of the present invention include various classes of dyes and pigments. Preferred colorants for this invention are pigments rather than dyes. Light fast colorants are preferred. The pigments are typically dispersed with an organic binder in an organic solvent or mixture of organic solvents. The pigments may be organic or inorganic. They are ground to a small enough particle size to duplicate the particle size and color of equivalent inks. The median diameter is generally less than 1 micrometer.

Nonexclusive examples of colorants usable in the present invention are as follows: Permanent Yellow G (C.I. 21095), Permanent Yellow GR (C.I. 21100), Permanent Yellow DHG (C.I. 21090), Permanent Rubine L6B (C.I. 15850:1), Permanent Pink F3B (C.I. 12433), Hostaperm Pink E (C.I. 73915), Hostaperm Red Violet ER (C.I. 46500), Permanent Carmine FBB (C.I. 12485), Hostaperm Blue B2G (C.I. 74160), Hostaperm Blue A2R (C.I. 74160), and Printex 25. Most of these pigments are products of Hoeschst AG. They can be used separately or blended for a desired color.

The colored photosensitive layer also contains a binder which not only determines the hardness and flexibility of the coating but is also used to control developability of the image. For example, if the binder is too soluble in the developer used, then the image will wash off. At the other extreme if binder is not soluble enough, then the image will not wash off.

Binders found suitable for this use are styrene/maleic anhydride copolymers and their half esters that can vary in monomer content at a ratio of from about 70/30 to about 95/5; methyl methacrlate/methacrylic acid copolymer having a ratio of monomers ranging from about 70/30 to 95/5; methyl methacrylate/ethyl acrylate/methacrylic acid copolymer having a ratio of monomers ranging from about 50/30/20 to about 90/5/5; and methyl methacrylate/butyl acrylate/methacrylic acid copolymer having a ratio of monomers ranging from about 50/30/20 to about 90/5/5. Binders with no acid value but with the solubility characteristics to develop properly in the alkaline aqueous developers are useful for the invention. Examples of this type of binder system nonexclusively include vinyl pyrrolidone polymers K-60 and K-90 available from GAF and resins of hydroxypropyl cellulose, methyl cellulose, and ethyl hydroxy ethyl cellulose.

In the preferred embodiment, the dry photosensitive layer has a coating weight range between approximately 0.1 and 5 $g/m^2$. The more preferred coating weight is between approximately 0.4 and 2 $g/m^2$.

In the practice of the present invention, the photopolymerizable monomer component is preferably present in the photosensitive layer in an amount ranging from about 10% to about 60% based on the weight of the solids in this layer. A more preferred range is from about 15% to about 40%.

In the practice of the present invention, the photoinitiator component is preferably present in the photosensitive layer in an amount ranging from about 2% to about 30% based on the weight of the solids in the layer. A more preferred range is from about 3% to about 20%.

The diazonium salt is preferably present in the composition of the subject invention at a percent solids level of from about 5% to about 30% by weight. More preferably, it is present from about 10% to about 20%.

In the practice of the present invention, the colorant component is preferably present in the photosensitive layer in an amount ranging from about 3% to about 50% based on the weight of the solids in the layer. A more preferred range is from about 5% to about 30%.

In the practice of the present invention, the binder component is preferably present in the photosensitive layer in an amount ranging from about 10% to about 75% based on the weight of the solids in the layer. A more preferred range is from about 20% to about 50%.

Suitable acid stabilizers useful within the context of this invention include phosphoric, citric, benzoic, m-nitro benzoic, p(p-anilino phenylazo) benzene sulfonic acid, 4,4'-dinitro-2,2'-stilbene disulfonic, itaconic, tartaric, p-toluene sulfonic acid, and mixtures thereof. Preferably, the acid stabilizer is phosphoric acid.

Exposure indicators which may be useful in conjunction with the present invention include eosin, azobenzene, Calcozine Fuchine dyes and Crystal Violet and Methylene Blue dyes. Preferably, the exposure indicator is 4-phenylazodiphenylamine.

The photoactivator which may be included in the composition of this invention should be an amine-containing photoactivator which combines synergistically with the free-radical photoinitiator to extend the effective half-life of the photoinitiator, which is normally in the approximate range of about $10^{-9}$ to $10^{-15}$ seconds. Suitable photoactivators include 2-(N-butoxy) ethyl-4-dimethylamino benzoate, 2-(dimethylamino) amino benzoate, and acrylated amines. Preferably the photoactivator is ethyl-4-dimethylamino benzoate.

A plasticizer may also be included in the composition of this invention to prevent coating brittleness and

EP 0 365 357 A2

to keep the composition pliable if desired. Suitable plasticizers include dibutylphthalate, dioctylphthalate, triarylphosphate and substituted analogs thereof.

Dyes may be included to spectrally sensitize the photoinitiator, such as described in U.S. Patents 4,282,309 and 4,454,218, and European Patent Applications 0,179,448 and 0,211,615.

The adhesive layer is next applied to the photosensitive layer. Its purpose is to aid in the transfer of the coating composite and to protect the integrity of underlying, previous formed images during development of subsequent layer or layers. The photosensitive layer should not be altered during the application of the adhesive solution to the photosensitive layer. Therefore, it is preferred to use a water dispersable resin which will not intrasolubilize with components from the photosensitive layer when applied and will not be solubilized by the alkaline developer in the dry state. The adhesive layers should not be tacky to the touch during storage and during development of the photosensitive element. It comprises one or more thermoplastic polymers. The layer is transferable in the range of from about 60°C to about 180°C, more preferably from about 60°C to about 120°C.

In one preferred embodiment, the adhesive composition is a dispersed aqueous mixture of a polymeric component. Polyvinyl acetate adhesives are preferred for this purpose. The adhesive film is activated with heat and, it is preferred, for this lamination transfer process, to use the adhesive with an activation temperature that is safely below that temperature that will cause distortion of the receiver sheet. Useful vinyl acetates polymers and copolymers nonexclusively include Monilith DM-6 and DM-22 available from Hoeschst AG; Gelva TS85 and TS100 available from Monsanto; Vinac XX-210 and 465 DEV from Air Products, and mixtures thereof.

Some adhesives may be applied by hot melt extrusion. Suitable adhesives for this method of application include the ethylene/vinyl acetate copolymers, such as Elvax 40-W and 150-W available from DuPont.

The preferred method for applying the adhesive to the photosensitive layer is by laminating the two together with heat and pressure. The adhesive is initially coated onto a temporary substrate. The dried adhesive can then be laminated directly to the photosensitive layer. Next, the temporary substrate is removed with the adhesive remaining on the photosensitive layer. The adhesive with the photosensitive layer on the support is then laminated to a receiver sheet. Alternatively, the dried adhesive on the temporary substrate can be laminated to a receiver sheet. Next, the temporary substrate is removed with the adhesive remaining on the receiver sheet. The photosensitive layer on its support is then laminated to the adhesive on the receiver sheet.

Acrylic polymers and copolymers are preferred for the lamination method for applying the adhesive to the photosensitive layer. Polyvinyl acetate polymers and copolymers are more preferred for this lamination method. Polyvinyl acetates are available from Hoeschst AG as Mowilith. These resins have an average molecular weight between 35,000 and 2,000,000. They have a softening temperature between about 80 and about 180°C. In the preferred embodiment, the polyvinyl acetate is present in the adhesive layer in an amount of greater than approximately 50% by weight. The adhesive resin should have a softening temperature in the range of approximately 40 to 200°C, more preferably 60 to 120°C.

The adhesive layer may optionally contain such other desired components as uv absorbers, antistatic compositions, inert fillers, optical brighteners, and plasticizers. Suitable uv absorbers include Uvinal D-50 available from GAF. Suitable antistatics include Gafac and Gafstat available from GAF. Suitable fillers include Nitrocellulose RS 1/2 available from Hercules. Suitable plasticizers include phthalates, nonexclusively including dibutyl phthalate, butyl benzyl phthalate, and dimethyl pthalate. Polymeric plasticizers, such as Resoflex R-296 available from Cambridge Industries, may also be used. The plasticizer may be present in the adhesive layer in an amount of up to approximately 30% by weight.

In the preferred embodiment, the dry adhesive layer has a coating weight range between approximately 2 and 30 g/m². The more preferred coating weight is between approximately 4 and 15 g/m². The thickness of the adhesive may be adjusted to regulate the apparent dot size of the final proof.

In operation, the photosensitive element is laminated to a receiver sheet via the adhesive layer. The receiver sheet should be resistant to any adverse effects which may be caused by lamination and development. For example, the receiver sheet should be water resistant if aqueous developers are used.

White plastic sheets, such as adhesion pretreated Melinex 3020 available from ICI, are useful as receiver sheets. Other white and nonwhite receiver sheets may also be used. Rough textured and adhesion promoted surfaces are preferred for the receiver sheets. Plastic coated paper sheets, such as polyethylene coated paper from Schoeller, may also be used. Other bases may include wood, glass, metal, and the like.

Lamination may be conducted by putting the receiver sheet in contact with the adhesive side of the photosensitive element and then introducing the two materials into the nip of a pair of heated laminating rollers under suitable pressure. Suitable laminating temperatures usually range from about 60°C to about

6

180°C, preferably from about 60°C to about 110°C. After lamination, the transparent support is peeled away, usually merely employing manual peeling forces. The adhesive and photosensitive layers thus are transferred to the receiver sheet.

The photosensitive layer is imagewise exposed by means well known in the art either before or after lamination. Such exposure may be conducted by exposure to actinic radiation through a conventional halftone negative color separation under vacuum frame conditions. Exposures after lamination and peel apart are preferred for emulsion-to-photosensitive layer contact. Mercury vapor discharge lamps are preferred over metal halide lamps. Other radiation sources, such as carbon arc, pulsed xenon, and lasers, may also be used. Light absorbing filters may be used to reduce light scattering in the material.

After lamination, support separation, and exposure in any of the above orders, the photosensitive layer is developed by dissolving the nonexposed area in a suitable developer and dried. The adhesive layer is not removed by this development.

In the preferred embodiment, the developer does not necessarily contain any organic solvent or solvents and need only contain a minor amount of salts and surfactants. There is a great advantage in the elimination of organic solvents in the developer composition due to the fact that such solvents are expensive and their effluent can be toxic. A suitable, organic solvent free, aqueous developer comprises an aqueous solution containing one or more of the following groups:

(a) a sodium, potassium, or lithium salt of octyl, decyl, or dodecyl monosulfate;

(b) a sodium, lithium, potassium, or ammonium metasilicate salt; and

(c) a lithium, potassium, sodium, or ammonium borate salt; and

(d) an aliphatic dicarboxylic acid, or sodium, potassium or ammonium salt thereof having from 2 to 6 carbon atoms; and

(e) mono, di-, or tri-sodium or -potassium phosphate.

Other suitable aqueous developers include benzoic acid, sodium, lithium or potassium benzoates, the hydroxy substituted analogs thereof, and mixtures thereof as well as those developers described in U.S. Pat. No. 4,436,807.

Specific examples of suitable developers nonexclusively include:

| I. | |
|---|---|
| Water | 95.0% |
| Sodium decyl sulphate | 3.0% |
| Disodium phosphate | 1.5% |
| Sodium metasilicate | 0.5% |

| II. | |
|---|---|
| Water | 89.264% |
| Monosodium phosphate | 0.269% |
| Trisodium phosphate | 2.230% |
| Sodium tetradecyl sulfate | 8.237% |

| III. | |
|---|---|
| Water | 88.5% |
| Monosodium phosphate | 0.5% |
| Trisodium phosphate | 2.5% |
| Sodium sulfate derivative of 7-ethyl-2-methyl, 4-undecanol | 8.5% |

Any developer solution which satisfactorily removes the nonexposed areas of the photosensitive layer after exposure while retaining the image areas may be used. The selection of developer is well within the ability of the skilled artisan.

7

After development, the imaged material on the receiver sheet along with the adhesive layer is rinsed generally with an aqueous solution and then dried.

The process of lamination, peel apart, exposure, and development can then be repeated whereby another photosensitive element having a different color is laminated to the same receiver sheet over the previously formed image. In the usual case, four colored layers are employed to produce a full color reproduction of a desired image. These are cyan, magenta, yellow and black.

The compositions of this invention which use both a photopolymer and a diazo in the mixture generally have a higher effective photospeed than comparable compositions employing only one of these sensitizer types. The result is unexpected because one would expect that the competition between these compounds for imaging energy during exposure would cause a net decrease in effective photospeed especially in the absence of an oxygen barrier, such as polyvinyl alcohol, on the photosensitive layer during exposure. The opposite has actually been unexpectedly found.

The following nonlimiting example serves to illustrate the invention.

## EXAMPLE

A photosensitive solution of cyan is produced according to the following photosensitive formulation by weight:

| polymethyl methacrylate/methacrylic acid (85/15) | 1.2 |
|---|---|
| polymethyl methacrylate/methacrylic acid (95/5) | 0.2 |
| phthalocyanine Blue | 0.2 |
| Above diazo from US 3,849,392 | 0.4 |
| trimethylol propane triacrylate | 1.0 |
| 9-phenyl acridine initiator | 0.2 |
| methyl ethyl ketone | 8.4 |
| methyl cellosolve | 7.0 |
| gamma-butyrolactone | 1.4 |
| optical density | 1.1 |

The pigment is introduced as a dispersion of methyl ethyl ketone, part of the PMMA 85/15, and the pigment. The solutions are coated and dried separately to the required optical density onto a 3 mil Melinex 516 polyester temporary support. The surface density is roughly 1.4 g/m². An adhesive solution is prepared by mixing the following components until homogenous:

| TS-85 polyvinyl acetate | 15.0 |
|---|---|
| Deionized water | 5.2 |

The adhesive solution is coated on top of the photosensitive layer and dried to a coating weight of 5.7 g/m². The cyan composite is then laminated at 80°C via the adhesive onto either side of a 7 mil Melinex 3020 polyester receiver sheet. The 516 temporary support is peeled away after lamination, leaving the adhesive and photosensitive layers on the receiver sheet. The cyan photosensitive layer is then exposed for 20 seconds to actinic light through a negative color separation for cyan in a Berkey Ascor exposure unit. The receiver sheet with the exposed cyan layer is then immersed for 15 seconds in developer II as described above at 27°C with gentle pad rubbing on the photosensitive side. The nonexposed, cyan areas are thereby washed off and the exposed areas remain during development. The adhesive layer is not effected by the developer. After this treatment, the imaged material is rinsed and then dried.

The same photosensitive solution is prepared but without the diazonium salt. This solution is identically processed as above. However, the exposure time is doubled to 40 seconds in order to obtain similar apparent sensitivity for optimum resolution and dot gain.

Similar photosensitive solutions containing the diazonium compound and photopolymerizable composition are prepared for the yellow, magenta, and black pigments. These solutions are coated and dried on other temporary supports of Melinex 516. The same adhesive is applied to these photosensitive layers. The resulting yellow, magenta, and black components are then sequentially laminated, peeled, exposed, and developed on the imaged cyan on the receiver sheet. This yields a four color proof which is an accurate representation of the original from which the four color separations are prepared.

## Claims

1. A multilayered imaging element which comprises in order:
   i. a transparent support having a release surface, and
   ii. a single, colored photosensitive composition layer directly on said release surface which photosensitive layer comprises in admixture a light sensitive component which component comprises both a polymeric diazonium compound and a photopolymerizable composition, at least one binding resin, and at least one colorant; wherein said polymerizable composition and diazonium compound are present in sufficient amount to cause image differentiation when the composition is imagewise exposed to actinic radiation; wherein said binding resin is present in sufficient amount to bind the photosensitive layer components into a uniform film; and wherein said colorant or colorants are present in sufficient amount to uniformly color said colored layer; and
   iii. a heat sensitive adhesive layer directly on said colored photosensitive layer.

2. The element of Claim 1 wherein said support comprises polyethylene terephthalate.

3. The element of Claim 1 wherein said support has a matte surface.

4. The element of Claim 1 wherein said release surface on said support comprises polyvinyl alcohol.

5. The element of Claim 1 wherein said diazonium salt comprises the polycondensation product of 3-methoxy-4-diazo-diphenylamine sulfate and 4,4'-bis-methoxymethyldiphenyl ether precipitated as mesitylene sulfonate.

6. The element of Claim 1 wherein said diazonium salt comprises the condensation product of 4,4'-bis-methoxymethyl diphenyl ether, which is first precondensed with itself to form an oligomer having from 2 to 7 repeating units, and 3-methoxy-4-diazo-diphenylamine sulfate.

7. The element of Claim 1 wherein said photopolymerizable composition comprises a photoinitiator and a photopolymerizable acrylate or methacrylate.

8. The element of Claim 7 wherein said photoinitiator comprises one or more compounds selected from the group consisting of p-methoxy phenyl quinoxaline and 9-phenyl acridine.

9. The element of Claim 7 wherein said photopolymerizable acrylate or methacrylate comprises one or more compounds selected from the group consisting of triethylene glycol dimethacrylate, tripropylene glycol diacrylate, tetraethylene glycol dimethacrylate, diethylene glycol dimethacrylate, 1,4-butanediol diacrylate, 1,6-hexanediol dimethacrylate, pentaerythritol tetraacrylate, trimethylol propane triacrylate, trimethylol propane trimethacrylate, di-pentaerythritol monohydroxypentaacrylate, pentaerthritol triacrylate, bisphenol A ethoxylate dimethacrylate, trimethylolpropane ethoxylate triacrylate, and trimethylolpropane propoxylate triacrylate.

10. The element of Claim 1 wherein said binding resin comprises one or more binders selected from the group consisting of styrene/maleic anhydride copolymers; half esters of styrene/maleic anhydride copolymers; methyl methacrylate/methacrylic acid copolymer; methyl methacrylate/ethyl acrylate/methacrylic acid copolymer; and methyl methacrylate/butyl acrylate/methacrylic acid copolymer.

11. The element of Claim 1 wherein said photosensitive layer further comprises one or more ingredients selected from the group consisting of plasticizers, acid stabilizers, surfactants, inert fillers, polymerization inhibitors, spectral sensitizers, antihalation agents, hydrogen atom donors, optical brighteners, exposure indicators, photoactivators, antistatic compositions, uv absorbers and surfactants.

12. The element of Claim 1 wherein said adhesive layer comprises one or more thermoplastic polymers having a softening temperature in the range of from about 60° C and 180° C.

13. The element of Claim 12 wherein said thermoplastic polymer or polymers comprise a compound selected from the group consisting of vinyl acetate polymer or copolymer.

14. The element of Claim 12 wherein said adhesive layer further comprises a plasticizer.

15. A method for forming a colored image which comprises:
   A. providing a multilayered imaging element which comprises in order:
   i. a transparent support having a release surface, and
   ii. a single, colored photosensitive composition layer directly on said release surface which photosensitive layer comprises in admixture a light sensitive component which component comprises both a polymeric diazonium compound and a photopolymerizable composition, at least one binding resin, and at least one

.colorant; wherein said polymerizable composition and diazonium compound are present in sufficient amount to cause image differentiation when the composition is imagewise exposed to actinic radiation; wherein said binding resin is present in sufficient amount to bind the photosensitive layer components into a uniform film; and wherein said colorant or colorants are present in sufficient amount to uniformly color said colored layer; and

iii. a heat sensitive activated adhesive layer directly on said colored photosensitive layer; and

    B. either

i. laminating said element with heat and pressure via said adhesive layer to a developer resistant receiver sheet; and removing said support by the application of peeling forces; and imagewise exposing said photosensitive layer to actinic radiation; or

ii. imagewise exposing said photosensitive layer to actinic radiation; and laminating said element with heat and pressure via said adhesive layer to a developer resistant receiver sheet; and removing said support by the application of peeling forces; or

iii. laminating said element with heat and pressure via said adhesive layer to a developer resistant receiver sheet; and imagewise exposing said photosensitive layer to actinic radiation; and removing said support by the application of peeling forces; and

    C. removing the nonexposed areas of said photosensitive layer with a liquid developer, which removing is conducted at a temperature at which said adhesive layer is substantially nontacky.

16. The method of Claim 15 wherein steps (A) through (C) are repeated at least once whereby another photosensitive element having at least one different colorant is laminated onto said receptor sheet over the nonremoved portions of the previously laminated photosensitive layer or layers.

17. The method of Claim 15 wherein said support comprises polyethylene terepthalate.

18. The method of Claim 15 wherein said support has a matte surface.

19. The method of Claim 15 wherein said release surface on said support comprises polyvinyl alcohol.

20. The method of Claim 15 wherein said diazonium salt comprises the polycondensation product of 3-methoxy-4-diazo-diphenylamine sulfate and 4,4'-bis-methoxymethyldiphenyl ether precipitated as mesitylene sulfonate.

21. The method of Claim 15 wherein said diazonium salt comprises the condensation product of 4,4'-bis-methoxymethyl diphenyl ether, which is first precondensed with itself to form an oligomer having from 2 to 7 repeating units, and 3-methoxy-4-diazo-diphenylamine sulfate.

22. The method of Claim 15 wherein said photosensitive layer further comprises one or more ingredients selected from the group consisting of plasticizers, acid stabilizers, surfactants, inert fillers, polymerization inhibitors, spectral sensitizers, antihalation agents, hydrogen atom donors, optical brighteners, exposure indicators, photoactivators, antistatic compositions, uv absorbers and surfactants.

23. The method of Claim 15 wherein said photopolymerizable composition comprises a photoinitiator and a photopolymerizable acrylate or methacrylate.

24. The method of Claim 23 wherein said photoinitiator comprises one or more compounds selected from the group consisting of p-methoxy phenyl quinoxaline and 9-phenyl acridine.

25. The method of Claim 23 wherein said photopolymerizable acrylate or methacrylate comprises one or more compounds selected from the group consisting of triethylene glycol dimethacrylate, tripropylene glycol diacrylate, tetraethylene glycol dimethacrylate, diethylene glycol dimethacrylate, 1,4-butanediol diacrylate, 1,6-hexanediol dimethacrylate, pentaerythritol tetraacrylate, trimethylol propane triacrylate, trimethylol propane trimethacrylate, di-pentaerythritol monohydroxypentaacrylate, pentaerthritol triacrylate, bisphenol A ethoxylate dimethacrylate, trimethylolpropane ethoxylate triacrylate, and trimethylolpropane propoxylate triacrylate.

26. The method of Claim 23 wherein said binding resin comprises one or more compounds selected from the group consisting of styrene/maleic anhydride copolymers; half estersof styrene/maleic anhydride copolymers; methyl methacrylate/methacrylic acid copolymer; methyl methacrylate/ethyl acrylate/methacrylic acid copolymer; and methyl methacrylate/butyl acrylate/methacrylic acid copolymer.

27. The method of Claim 15 wherein said adhesive layer comprises one or more thermoplastic polymers having a softening temperature in the range of from about 60° C and 180° C.

28. The method of Claim 27 wherein said thermoplastic polymer or polymers comprise a compound selected from the group consisting of vinyl acetate polymer or copolymer.

29. The method of Claim 15 wherein said adhesive layer further comprises a plasticizer.

30. The method of Claim 15 wherein said exposure is conducted with an energy source selected from the group consisting of visible, ultraviolet, x-ray, laser, election beam, and ion beam radiations.

31. The method of Claim 15 wherein said developer is organic solvent free and comprises one or more compositions selected form the group consisting of water; aqueous solutions of alkali metal benzoates; and

an aqueous solution containing one or more of the following groups:

(a) a sodium, potassium, or lithium salt of octyl, decyl, or dodecyl monosulfate:

(b) a sodium, lithium, potassium, or ammonium metasilicate salt; and

(c) a lithium, potassium, sodium, or ammonium borate salt; and

(d) an aliphatic dicarboxylic acid, or sodium, potassium or ammonium salt thereof having from 2 to 6 carbon atoms; and

(e) mono, di-, or tri-sodium or -potassium phosphate.